# EUROPÄISCHE PATENTSCHRIFT

(11) **EP 3 424 283 B1**
(45) Veröffentlichungstag und Bekanntmachung des Hinweises auf die Patenterteilung: **11.08.2021**
(21) Anmeldenummer: 17703318.0
(22) Anmeldetag: 02.02.2017
(51) Int. Cl.: H05K 1/11, H01R 12/65, H05K 3/20

(54) **SCHALTKREIS EINER ELEKTRONISCHEN STEUEREINHEIT**
CIRCUIT OF AN ELECTRONIC CONTROL UNIT
CIRCUIT DE COMMUTATION D'UNE UNITÉ DE COMMANDE ÉLECTRONIQUE

(30) Priorität: 05.03.2016 DE 102016002821
(43) Veröffentlichungstag der Anmeldung: 09.01.2019
(73) Patentinhaber: ZF CV Systems Europe BV, 1170 Brussels (BE)
(72) Erfinder: BRAMMER, Christian, 29303 Bergen (DE); WUSTRACK, Tobias, 30890 Barsinghausen (DE)
(74) Vertreter: Koschnitzki, Thomas
(86) Internationale Anmeldenummer: PCT/EP2017/000134
(87) Internationale Veröffentlichungsnummer: WO 2017/153029

(56) Entgegenhaltungen:
- WO-A1-2005/078867
- DE-A1-102010 039 204

## Beschreibung

Die Erfindung betrifft einen Schaltkreis einer elektronischen Steuereinheit, mit mehreren in Stanzgitterbauweise oder in Flexfolienbauweise hergestellten Leiterbahnen, von denen zumindest eine Leiterbahn einen Kontaktbereich mit mindestens einer Leiterbahn-Kontaktbohrung zum Einpressen eines Kontaktstiftes eines Steckerelementes oder eines elektronischen Bauteils aufweist.

Bei elektronischen Steuereinheiten, wie zum Beispiel Steuergeräte von Kraftfahrzeugen, über welche größere elektrische Ströme verteilt werden, müssen die Leiterbahnen entsprechend große Leitungsquerschnitte aufweisen. Zudem sollen die Steuereinheiten möglichst wenig Bauraum einnehmen und den vorhandenen Bauraum optimal ausnutzen, welches durch eine gewölbte oder geknickte Bauweise erreicht werden kann. Die Leiterbahnen der Schaltkreise von elektronischen Steuereinheiten sind daher häufig in Stanzgitterbauweise oder in Flexfolienbauweise hergestellt, da diese durch Biegen, Wölben und Knicken eine flexible, von einer ebenen Platine abweichende Formgestaltung ermöglichen.

Bei einem in Stanzgitterbauweise ausgeführten Schaltkreis werden die Leiterbahnen aus einem Blechstreifen aus elektrisch leitendem Metall, wie zum Beispiel aus einem Kupferblech, ausgestanzt, wobei die Leiterbahnen zunächst über Verbindungsstege miteinander verbunden sind. Anschließend werden die Leiterbahnen zum Beispiel abschnittweise mit einem elektrisch nicht leitenden Kunststoff umspritzt und damit mechanisch miteinander verbunden. Nach dem Aushärten des Kunststoffes werden die Verbindungsstege ausgestanzt, so dass die Leiterbahnen dann elektrisch voneinander getrennt sind und durch Biegen sowie Knicken in eine geeignete Form gebracht werden können.

Bei einem in Flexfolienbauweise ausgeführten Schaltkreis werden die Leiterbahnen zum Beispiel vollständig aus einem Blechstreifen aus elektrisch leitendem Metall ausgestanzt und anschließend beidseitig durch Verkleben mit einer elektrisch nicht leitenden flexiblen Kunststofffolie miteinander verbunden. Die Leiterbahnen sind somit elektrisch voneinander getrennt und können durch Biegen und Knicken in eine geeignete Form gebracht werden.

Zur rationellen Bestückung der Schaltkreise mit Steckerelementen, wie zum Beispiel Steckerbuchsen zum Ein- oder Aufstecken von Kabelsteckern, und mit elektronischen Bauteilen, wie Transistoren, Widerständen, Kondensatoren und so weiter, werden zunehmend lötfreie Steckverbindungen verwendet, über welche die betreffenden Bauteile sowohl mechanisch auf der betreffenden Leiterbahn befestigt als auch elektrisch mit dieser verbunden werden. Hierzu weisen die Leiterbahnen jeweils zumindest einen Kontaktbereich mit mindestens einer Leiterbahn-Kontaktbohrung zum Einpressen eines Kontaktstiftes eines Steckerelementes oder eines elektronischen Bauteils auf.

In der DE 10 2004 006 575 A1 ist ein in Stanzgitterbauweise ausgeführter Leistungsverteiler beschrieben, bei dem Steckerelemente mit zwei oder drei Kontaktstiften in zugeordnete Kontaktbohrungen der Leiterbahnen eingepresst sind.

Aus der DE 20 2009 009 933 U1 ist ein in Stanzgitterbauweise ausgeführter Schaltkreis einer elektronischen Steuereinheit bekannt, bei dem die vorgesehenen Steckerelemente zumindest im Sockelbereich U-förmig gebogen ausgeführt sind und an jedem Sockelschenkel zwei Kontaktstifte zum Einpressen in jeweils zwei Leiterbahn-Kontaktbohrungen benachbarter Leiterbahnen aufweisen.

In der DE 10 2010 039 204 A1 ist ein in Flexfolienbauweise ausgeführter Schaltkreis einer elektronischen Steuereinheit beschrieben, bei dem die Leiterbahnen an deren Kontaktbohrungen verstärkt sind. In einer ersten Ausführungsform ist in eine entsprechend vergrößerte Leiterbahn-Kontaktbohrung eine Buchse oder ein Hohlniet eingesetzt. In einer zweiten Ausführungsform ist eine Leiterbahn an der entsprechend vergrößerten Leiterbahn-Kontaktbohrung in einer ringförmigen Kontur mit einem elektrisch leitenden Kunststoff umspritzt. Die Verstärkung der Leiterbahnen im unmittelbaren Bereich der Leiterbahn-Kontaktbohrung dient zur Vergrößerung der elektrischen Kontaktfläche mit den Kontaktstiften. Eine mechanische Versteifung der Kontaktbereiche der Leiterbahnen wird dadurch jedoch kaum erreicht.

Ein bekanntes Problem bei der Bestückung von in Stanzgitterbauweise und in Flexfolienbauweise ausgeführten Schaltkreisen besteht darin, dass die Kontaktbereiche beim Einpressen der Kontaktstifte von Steckerelementen und elektronischen Bauteilen in die zugeordneten Kontaktbohrungen ungewollt verformt werden. Hierdurch können sich eine ungünstige Lage und eine unzureichende mechanische Befestigung der betreffenden Bauteile ergeben. Ebenso kann der elektrische Kontakt zwischen den Leiterbahn-Kontaktbohrungen und den Kontaktstiften der Bauteile dadurch beeinträchtigt sein. Das Problem tritt besonders dann auf, wenn die Leiterbahnen aus einem Blech mit einer vergleichsweise geringen Dicke von beispielsweise weniger als 1 mm ausgestanzt sind.

Der vorliegenden Erfindung liegt daher die Aufgabe zugrunde, für einen Schaltkreis einer elektronischen Steuereinheit der eingangs genannten Art, bei dem die Leiterbahnen eine relativ geringe Blechstärke aufweisen, eine einfach und kostengünstig herstellbare sowie montierbare Verstärkung der Leiterbahnen an den Kontaktbereichen vorzuschlagen, mittels der eine Verformung der Leiterbahnen auch bei einem robusten Einpressen der Kontaktstifte in die Leiterbahn-Kontaktbohrungen sicher verhindert wird.

Unter einer relativ geringen Blechstärke wird eine Blechstärke verstanden, die so gering ist, dass das Blech vergleichsweise leicht zu biegen ist und/oder Biegebelastungen aufgrund dessen Flexibilität im Betrieb schadlos standhalten kann. Eine in diesem Sinne relativ geringe Blechstärke kann kleiner oder gleich 0,8 mm betragen und auch als Folie bezeichnet werden.

Diese Aufgabe ist durch einen Schaltkreis mit den Merkmalen des Anspruchs 1 gelöst. Vorteilhafte Ausgestaltungen und Weiterbildungen dieses Schaltkreises sind Gegenstand der abhängigen Ansprüche.

Die Erfindung geht demnach aus von einem an sich bekannten Schaltkreis einer elektronischen Steuereinheit, die mehrere in Stanzgitterbauweise oder in Flexfolienbauweise hergestellte Leiterbahnen aufweist. Bei diesem Schaltkreis weist zumindest eine Leiterbahn einen Kontaktbereich mit mindestens einer Leiterbahn-Kontaktbohrung zum Einpressen eines Kontaktstiftes eines Steckerelementes oder eines elektronischen Bauteils auf.

Um bei einer relativ geringen Blechstärke der Leiterbahnen von zum Beispiel 0,8 mm oder weniger eine Verformung der Leiterbahnen beim Einpressen der Kontaktstifte in die Leiterbahn-Kontaktbohrungen zu verhindern, ist bei diesen Schaltkreis vorgesehen, dass der Kontaktbereich der Leiterbahn mit einer zusätzlichen Stützscheibe verstärkt ist, dass die Stützscheibe aus einem elektrisch leitenden Metallblech besteht, dass die Stützscheibe den Kontaktbereich der Leiterbahn abdeckt, dass die Stützscheibe mit einer Stützscheiben-Kontaktbohrung versehen ist, dass die Stützscheiben-Kontaktbohrung koaxial zu der Leiterbahn-Kontaktbohrung angeordnet ist, und dass die Stützscheibe auf einer Seite der Leiterbahn angeordnet sowie mit der Leiterbahn verbunden ist.

Somit ist der Kontaktbereich der Leiterbahn versteift, wodurch eine Verformung der Leiterbahn im Bereich der Leiterbahn-Kontaktbohrung beim Einpressen des Kontaktstiftes auf einfache und kostengünstige Weise verhindert ist. Als positiver Nebeneffekt ist durch die Stützscheibe auch die Kontaktfläche für den Kontaktstift vergrößert und damit der elektrische Kontakt zwischen der Leiterbahn und dem Steckerelement oder dem elektronischen Bauteil verbessert. Die Stützscheibe kann aus einem entsprechend dicken Blech ausgeschnitten oder ausgestanzt sein und in identischer Ausführung an mehreren Kontaktbereichen des Schaltkreises angeordnet sein.

Die Stützscheibe ist bevorzugt auf derjenigen Seite der Leiterbahn angeordnet, von der aus der Kontaktstift des Steckerelementes oder des elektronischen Bauteils in die Leiterbahn-Kontaktbohrung eingesetzt wird. Hierdurch wird die Stützscheibe beim Einpressen des Kontaktstiftes in die Leiterbahn-Kontaktbohrung an die Leiterbahn angedrückt, so dass die Verbindung zwischen der Stützscheibe und der Leiterbahn weniger robust ausgeführt werden kann.

Um eine große Stabilität aufzuweisen und den Kontaktbereich der Leiterbahn hinreichend zu versteifen, weist die Stützscheibe vorzugsweise mindestens die dreifache Dicke der Leiterbahn auf. Bei einer solchen Ausführungsform ist die Stützscheibe ausreichend steif auch für ein robustes Einpressen der Kontaktstifte.

Die Stützscheibe ist mittels einer Umspritzung mit einem Kunststoff mit der Leiterbahn verbunden. Der verwendete Kunststoff kann wahlweise elektrisch leitend oder nicht leitend sein.

Die Kunststoffumspritzung der Leiterbahn und der Stützscheibe ist bevorzugt rahmenförmig ausgebildet und umfasst die Außenränder der Leiterbahn und der Stützscheibe klammerartig. Hierdurch ist eine stabile formschlüssige Verbindung zwischen der Stützscheibe und der Leiterbahn gegeben. Im Vergleich zu einer ebenfalls möglichen nietförmigen Umspritzung mehrerer Bohrungen ist bei der rahmenförmigen Umspritzung keine Befestigungsbohrung erforderlich.

Um beim Einpressen des Kontaktstiftes eine Auswölbung der Leiterbahn im Bereich der Leiterbahn-Kontaktbohrung zu vermeiden, ist der Durchmesser der Leiterbahn-Kontaktbohrung bei den vorgenannten Ausführungen bevorzugt so weit vergrößert, dass eine elektrische Verbindung der Leiterbahn mit dem Kontaktstift des Steckerelementes oder des elektronischen Bauteils nur über die Stützscheiben-Kontaktbohrung besteht. Aufgrund der relativ großen Dicke der Stützscheibe ist die Kontaktfläche der Stützscheibe mit dem Kontaktstift des Steckerelementes oder des elektronischen Bauteils völlig ausreichend.

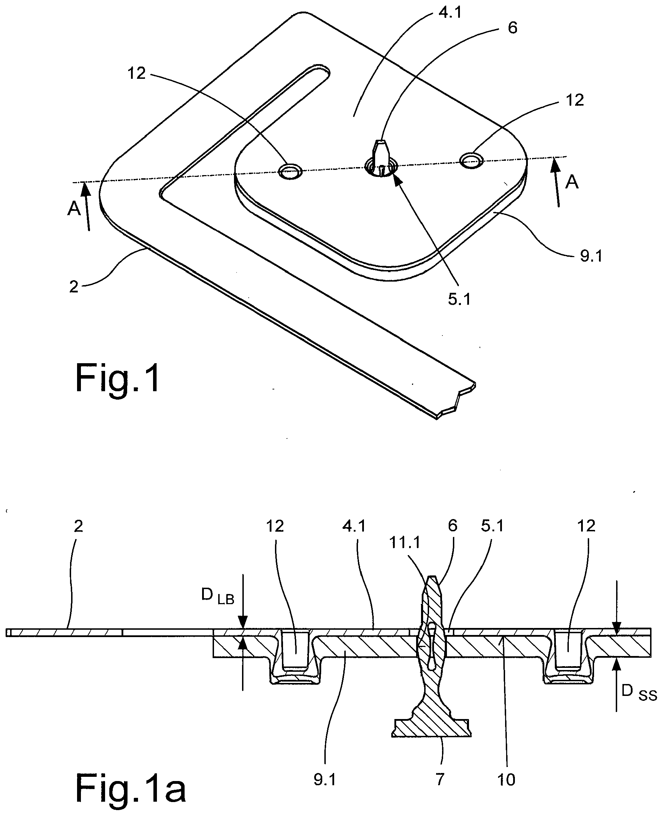

Die Erfindung wird nachstehend in den beigefügten Zeichnungen näher erläutert. In der Zeichnung zeigt
Fig. 1 eine Ausführungsform eines nicht gemäß der Erfindung ausgebildeten Kontaktbereiches einer Leiterbahn in einer perspektivischen Ansicht,
Fig. 1 a der Kontaktbereich der Leiterbahn gemäß Fig. 1 in einer Schnittansicht,
Fig. 2 ein Schaltkreis einer elektronischen Steuereinheit mit mehreren Leiterbahnen und Kontaktbereichen in einer perspektivischen Ansicht,
Fig. 3 eine Ausführungsform eines gemäß der Erfindung ausgebildeten Kontaktbereiches einer Leiterbahn in einer perspektivischen Ansicht,
Fig. 3a der Kontaktbereich der Leiterbahn gemäß Fig. 3 in einer Schnittansicht,
Fig. 4 eine Ausführungsform eines nicht gemäß der Erfindung ausgebildeten Kontaktbereiches einer Leiterbahn in einer perspektivischen Ansicht, und
Fig. 4a der Kontaktbereich der Leiterbahn gemäß Fig. 4 in einer Schnittansicht.

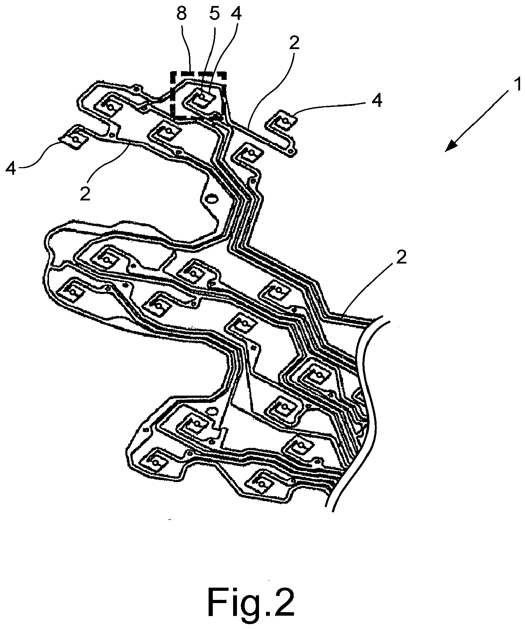

In Fig. 2 ist ein in Stanzgitterbauweise hergestellter Schaltkreis 1 einer elektronischen Steuereinheit abgebildet, der mehrere Leiterbahnen 2 umfasst, welche elektrisch voneinander getrennt sind. Die Leiterbahnen 2 weisen jeweils zumindest einen Kontaktbereich 4 mit mindestens einer Leiterbahn-Kontaktbohrung 5 zum Einpressen eines Kontaktstiftes 6 eines Steckerelementes 7 oder eines elektronischen Bauteils auf. Nachfolgend wird die Erfindung anhand des in Fig. 2 durch einen gestrichelten Rahmen 8 markierten Kontaktbereiches 4 einer Leiterbahn 2 in drei Ausführungen erläutert.

Eine Ausführungsform eines nicht erfindungsgemäßen Kontaktbereiches 4.1 der Leiterbahn 2 ist in Fig. 1 in einer perspektivischen Ansicht und in Fig. 1a in einer Schnittansicht entlang der Schnittlinie A-A gemäß Fig. 1 dargestellt. Die Leiterbahn 2 ist aus einem Blechstreifen ausgeschnitten oder ausgestanzt, dessen Dicke D_{LB} in diesem Ausführungsbeispiel maximal 0,8 mm beträgt (D_{LB} ≤ 0,8 mm). Um eine Verformung der Leiterbahn 2 beim Einsetzen des Kontaktstiftes 6 in die Leiterbahn-Kontaktbohrung 5.1 zu verhindern beziehungsweise um auch ein robustes und dennoch schadloses Einpressen des Kontaktstiftes 6 in die Leiterbahn-Kontaktbohrung 5.1 zu ermöglichen, ist der Kontaktbereich 4.1 der Leiterbahn 2 mit einer zusätzlichen Stützscheibe 9.1 verstärkt. Die Stützscheibe 9.1 besteht aus einem elektrisch leitenden Metallblech vergleichsweise großer Dicke D_{SS}, wie zum Beispiel aus einem Kupferblech, und deckt den gesamten Kontaktbereich 4.1 der Leiterbahn 2 ab. Die Stützscheibe 9.1 ist in diesem Beispiel auf der Unterseite 10 der Leiterbahn 2 angeordnet, von der aus der Kontaktstift 6 des Steckerelementes 7 oder des elektronischen Bauteils in die Leiterbahn-Kontaktbohrung 5.1 eingesetzt wird. Außerdem weist die Stützscheibe 9.1 eine koaxial zur Leiterbahn-Kontaktbohrung 5.1 angeordnete, durchgängige Stützscheiben-Kontaktbohrung 11.1 auf. Vorliegend ist die Stützscheibe 9.1 mittels einer an zwei Stellen ausgeführten Clinchnietverbindung 12 mit der Leiterbahn 2 verbunden. Der Durchmesser der Leiterbahn-Kontaktbohrung 5.1 ist so groß, dass eine elektrische Verbindung der Leiterbahn 2 mit dem Kontaktstift 6 des Steckerelementes 7 oder des elektronischen Bauteils nur über die Stützscheiben-Kontaktbohrung 11.1 besteht. Hierdurch wird eine Auswölbung der Leiterbahn 2 im Bereich der Leiterbahn-Kontaktbohrung 5.1 beim Einsetzen des Kontaktstiftes 6 vorteilhaft verhindert.

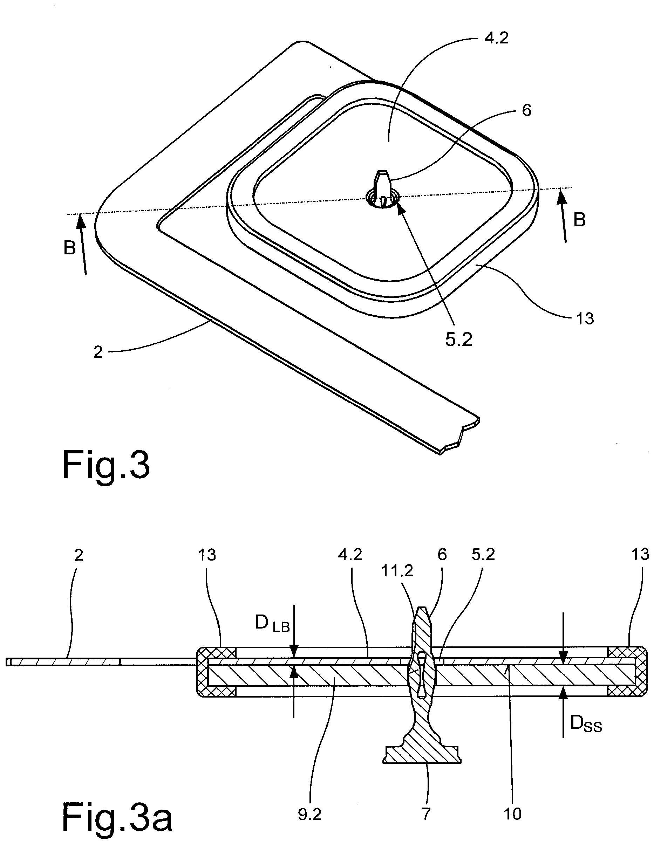

Eine Ausführungsform eines erfindungsgemäßen Kontaktbereiches 4.2 der Leiterbahn 2 ist in Fig. 3 in einer perspektivischen Ansicht und in Fig. 3a in einer Schnittansicht entlang der Schnittlinie B-B gemäß Fig. 3 dargestellt. Die Stützscheibe 9.2 ist bei dieser Ausführung des Kontaktbereiches 4.2 ebenfalls auf derjenigen Unterseite 10 der Leiterbahn 2 angeordnet, von der aus der Kontaktstift 6 des Steckerelementes 7 oder des elektronischen Bauteils in die Leiterbahn-Kontaktbohrung 5.2 eingesetzt wird, und mit einer positionsrichtig, also koaxial zur Leiterbahn-Kontaktbohrung 5.2 angeordneten Stützscheiben-Kontaktbohrung 11.2 versehen. Nun ist die Stützscheibe 9.2 jedoch mittels einer Umspritzung 13 aus einem Kunststoff mit der Leiterbahn 2 verbunden. Die Kunststoffumspritzung 13 der Leiterbahn 2 und der Stützscheibe 9.2 ist rahmenförmig ausgebildet und umfasst die Außenränder der Leiterbahn 2 sowie der Stützscheibe 9.2 rahmenartig. Der verwendete Kunststoff kann wahlweise elektrisch leitend oder nicht leitend ausgebildet sein. Auch bei dieser Ausführung des Kontaktbereiches 4.2 ist der Durchmesser der Leiterbahn-Kontaktbohrung 5.2 so weit vergrößert, dass eine elektrische Verbindung der Leiterbahn 2 mit dem Kontaktstift 6 des Steckerelementes 7 oder des elektronischen Bauteils ausschließlich über die Stützscheiben-Kontaktbohrung 11.2 besteht.

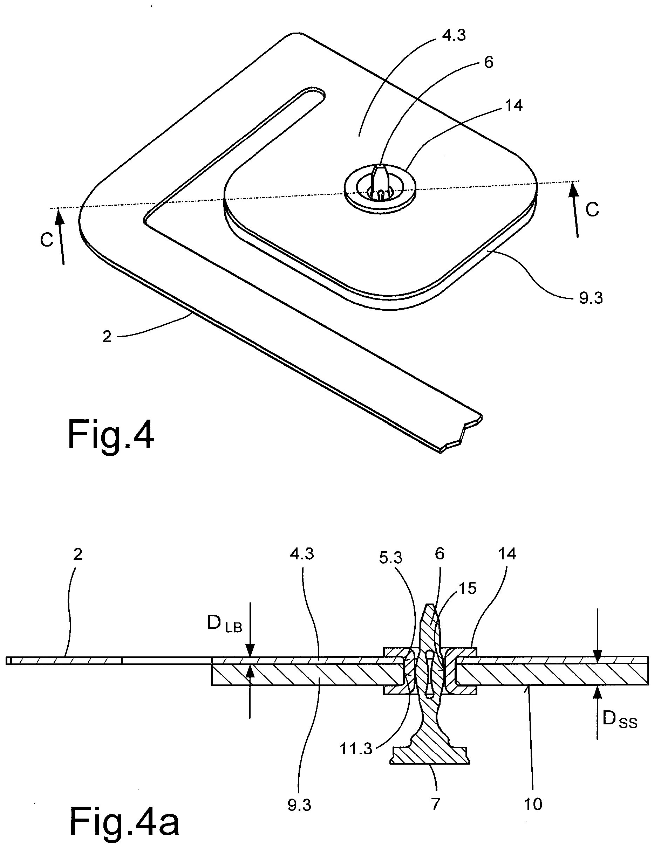

Eine Ausführungsform eines nicht erfindungsgemäßen Kontaktbereiches 4.3 der Leiterbahn 2 ist in Fig. 4 in einer perspektivischen Ansicht und in Fig. 4a in einer Schnittansicht entlang der Schnittlinie C - C gemäß Fig. 4 dargestellt. Die Stützscheibe 9.3 ist auch bei dieser Ausführung des Kontaktbereiches 4.3 auf der Unterseite 10 der Leiterbahn 2 angeordnet, von der aus der Kontaktstift 6 des Steckerelementes 7 oder des elektronischen Bauteils in die Leiterbahn-Kontaktbohrung 5.3 eingesetzt wird, und mit einer positionsrichtig angeordneten Stützscheiben-Kontaktbohrung 11.3 versehen. Nun ist die Stützscheibe 9.3 jedoch mittels einer aus einem elektrisch leitenden Metall bestehenden Hülse 14 oder eines Hohlniets mit der Leiterbahn 2 verbunden, welche in die entsprechend erweiterten Kontaktbohrungen 5.3, 11.3 der Leiterbahn 2 beziehungsweise der Stützscheibe 9.3 eingesetzt sowie axial endseitig umgebördelt ist. Die elektrische Verbindung der Leiterbahn 2 mit dem Kontaktstift 6 des Steckerelementes 7 oder des elektronischen Bauteils besteht hierbei über die relativ große zylindrische Innenfläche 15 der Hülse 14 oder des Hohlniets.

## Patentansprüche

1. Schaltkreis (1) einer elektronischen Steuereinheit, mit mehreren in Stanzgitterbauweise oder in Flexfolienbauweise hergestellten Leiterbahnen (2), von denen zumindest eine Leiterbahn (2) einen Kontaktbereich (4, 4.1, 4.2, 4.3) mit mindestens einer Leiterbahn-Kontaktbohrung (5, 5.1, 5.2, 5.3) zum Einpressen eines Kontaktstiftes (6) eines Steckerelementes (7) oder eines elektronischen Bauteils aufweist, wobei der Kontaktbereich (4, 4.1, 4.2, 4.3) der Leiterbahn (2) mit einer zusätzlichen Stützscheibe (9, 9.1, 9.2, 9.3) verstärkt ist, wobei die Stützscheibe (9, 9.1, 9.2, 9.3) aus einem elektrisch leitenden Metallblech besteht, wobei die Stützscheibe (9, 9.1, 9.2, 9.3) den Kontaktbereich (4) der Leiterbahn (2) abdeckt, wobei die Stützscheibe (9, 9.1, 9.2, 9.3) mit einer Stützscheiben-Kontaktbohrung (11, 11.1, 11.2, 11.3) versehen ist, wobei die Stützscheiben-Kontaktbohrung (11, 11.1, 11.2, 11.3) koaxial zu der Leiterbahn-Kontaktbohrung (5, 5.1, 5.2, 5.3) angeordnet ist, und wobei die Stützscheibe (9, 9.1, 9.2, 9.3) auf einer Seite (10) der Leiterbahn (2) angeordnet sowie mit der Leiterbahn (2) verbunden ist, wobei die Stützscheibe (9.2) mittels einer Umspritzung (13) mit einem Kunststoff mit der Leiterbahn (2) verbunden ist, und
wobei die Umspritzung der Leiterbahn (2) und der Stützscheibe rahmenförmig ausgebildet ist und die Außenränder der Leiterbahn (2) sowie der Stützscheibe rahmenartig umfasst.

2. Schaltkreis nach Anspruch 1, **dadurch gekennzeichnet, dass** die Stützscheibe (9, 9.1, 9.2, 9.3) auf derjenigen Seite (10) der Leiterbahn (2) angeordnet ist, von der aus der Kontaktstift (6) des Steckerelementes (7) oder des elektronischen Bauteils (7) in die Leiterbahn-Kontaktbohrung (5, 5.1, 5.2, 5.3) eingesetzt wird.

3. Schaltkreis nach Anspruch 1 oder 2, **dadurch gekennzeichnet, dass** die Stützscheibe (9, 9.1, 9.2, 9.3) mindestens die dreifache Dicke (D_{LB}) der Leiterbahn (2) aufweist.

4. Schaltkreis nach Anspruch 1, **dadurch gekennzeichnet, dass** die Kunststoffumspritzung (13) der Leiterbahn (2) und der Stützscheibe (9.2) rahmenförmig ausgebildet ist und die Außenränder der Leiterbahn (2) und der Stützscheibe (9.2) klammerförmig umfasst.

5. Schaltkreis nach einem der Ansprüchel oder 5, **dadurch gekennzeichnet, dass** der Durchmesser der Kontaktbohrung (5.1, 5.2) der Leiterbahn (2) so weit vergrößert ist, dass eine elektrische Verbindung der Leiterbahn (2) mit dem Kontaktstift (6) des Steckerelementes (7) oder des elektronischen Bauteils (7) nur über die Kontaktbohrung (11.1, 11.2) der Stützscheibe (9.1, 9.2) besteht.

## Claims

1. A circuit (1) of an electronic control unit comprising a plurality of conductor tracks (2) manufactured in punched-grid constructional form or in flexible-film constructional form, of which at least one conductor track (2) comprises a contact region (4, 4.1, 4.2, 4.3) with at least one conductor-track contact bore (5, 5.1, 5.2, 5.3) for pressing in a contact pin (6) of a connector element (7) or an electronic component; wherein the contact region (4, 4.1, 4.2, 4.3) of the conductor track (2) is reinforced with an additional supporting washer (9, 9.1, 9.2, 9.3), wherein the supporting washer (9, 9.1, 9.2, 9.3) consists of an electrically conducting metal sheet, wherein the supporting washer (9, 9.1, 9.2, 9.3) covers the contact region (4) of the conductor track (2), wherein the supporting washer (9, 9.1, 9.2, 9.3) is provided with supporting-washer contact bore (11, 11.1, 11.2, 11.3), wherein the supporting-washer contact bore (11, 11.1, 11.2, 11.3) is arranged coaxially with respect to the conductor-track contact bore (5, 5.1, 5.2, 5.3), and wherein the supporting washer (9, 9.1, 9.2, 9.3) is arranged on one side (10) of the conductor track (2) and also connected to the conductor track (2), wherein the supporting washer (9.2) is connected by means of an extrusion (13) with a plastic to the conductor track (2), and
wherein the extrusion of the conductor track (2) and of the supporting washer is formed like a frame and the outer edges of the conductor track (2) as well of the supporting washer comprise frames.

2. The circuit according to claim 1, **characterized in that** the supporting washer (9, 9.1, 9.2, 9.3) is arranged on the side (10) of the conductor track (2) from which the contact pin (6) of the connector element (7) or of the electronic component (7) is inserted into the conductor-track contact bore (5, 5.1, 5.2, 5.3).

3. The circuit according to claim 1 or 2, **characterized in that** the supporting washer (9, 9.1, 9.2, 9.3) has a thickness (D_{LB}) at least three times the thickness of the conductor track (2) .

4. The circuit according to claim 1, **characterized in that** the plastic extrusion (13) of the conductor track (2) and of the supporting washer (9.2) is formed like a frame and the outer edges of the conductor track (2) and of the supporting washer (9.2) comprise a clip.

5. The circuit according to any of claims 1 or 5, **characterized in that** the diameter of the contact bore (5.1, 5.2) of the conductor track (2) is enlarged such that an electrical connection of the conductor track (2) to the contact pin (6) of the connector element (7) or of the electronic component (7) exists only via the contact bore (11.1, 11.2) of the supporting washer (9.1, 9.2).

## Revendications

1. Circuit (1) d'une unité de commande électronique, avec plusieurs tracés conducteurs (2) produits à la manière d'une grille estampée ou à la manière d'un film flexible, dont au moins un tracé conducteur (2) présente une zone de contact (4, 4.1, 4.2, 4.3) avec au moins un trou de contact de tracé conducteur (5, 5.1, 5.2, 5.3) pour l'insertion d'une broche de contact (6) d'un élément de connecteur (7) ou d'un composant électronique, dans lequel la zone de contact (4, 4.1, 4.2, 4.3) du tracé conducteur (2) est renforcée avec un disque de support (9, 9.1, 9.2, 9.3) additionnel, dans lequel le disque de support (9, 9.1, 9.2, 9.3) est constitué d'une tôle métallique électro-conductrice, dans lequel le disque de support (9, 9.1, 9.2, 9.3) recouvre la zone de contact (4) du tracé conducteur (2), dans lequel le disque de support (9, 9.1, 9.2, 9.3) est pourvu d'un trou de contact de disque de support (11, 11.1, 11.2, 11.3), dans lequel le trou de contact de disque de support (11, 11.1, 11.2, 11.3) est disposé de manière coaxiale par rapport au trou de contact de tracé conducteur (5, 5.1, 5.2, 5.3), et dans lequel le disque de support (9, 9.1, 9.2, 9.3) est disposé sur une face (10) du tracé conducteur (2) ainsi que relié au tracé conducteur (2), dans lequel le disque de support (9.2) est relié au tracé conducteur (2) au moyen d'un surmoulage (13) avec une matière plastique, et
dans lequel le surmoulage du tracé conducteur (2) et du disque de support est réalisé en forme de cadre et entoure les bords extérieurs du tracé conducteur (2) ainsi que du disque de support à la façon d'un cadre.

2. Circuit selon la revendication 1, **caractérisé en ce que** le disque de support (9, 9.1, 9.2, 9.3) est disposé sur la face (10) du tracé conducteur (2) à partir de laquelle la broche de contact (6) de l'élément de connecteur (7) ou du composant électronique (7) est insérée dans le trou de contact de tracé conducteur (5, 5.1, 5.2, 5.3).

3. Circuit selon la revendication 1 ou 2, **caractérisé en ce que** le disque de support (9, 9.1, 9.2, 9.3) présente au moins trois fois épaisseur (D_{LB}) du tracé conducteur (2).

4. Circuit selon la revendication 1, **caractérisé en ce que** le surmoulage en matière plastique (13) du tracé conducteur (2) et du disque de support (9.2) est réalisé en forme de cadre et entoure les bords extérieurs du tracé conducteur (2) et du disque de support (9.2) en forme d'agrafe.

5. Circuit selon l'une quelconque des revendications 1 ou 5, **caractérisé en ce que** le diamètre du trou de contact (5.1, 5.2) du tracé conducteur (2) est augmenté à un point tel qu'une liaison électrique du tracé conducteur (2) avec la broche de contact (6) de l'élément de connecteur (7) ou du composant électronique (7) n'est présente que par l'intermédiaire du trou de contact (11.1, 11.2) du disque de support (9.1, 9.2).
